Europäisches Patentamt

European Patent Office

Office européen des brevets

(11) Veröffentlichungsnummer: **0 306 653**
**A1**

# EUROPÄISCHE PATENTANMELDUNG

(21) Anmeldenummer: 88110881.5

(22) Anmeldetag: 07.07.88

(51) Int. Cl.⁴: **G01R 31/28 , H05K 13/08 , H05K 13/04**

(30) Priorität: 20.08.87 DE 3727832

(43) Veröffentlichungstag der Anmeldung:
15.03.89 Patentblatt 89/11

(84) Benannte Vertragsstaaten:
**AT BE CH DE FR GB IT LI NL SE**

(71) Anmelder: **Siemens Aktiengesellschaft Berlin und München**
**Wittelsbacherplatz 2**
**D-8000 München 2(DE)**

(72) Erfinder: **Aldinger, Ulrich, Dipl.-Ing.**
**Zittelstrasse 4**
**D-8000 München 40(DE)**

(54) **Einrichtung zur Positionierung von IC-Bausteinen auf einem Substrat.**

(57) Die aus einer Zuführeinrichtung entnommenen IC-Bausteine (B) werden vor dem Bestückvorgang der zugeordneten Kontaktiervorrichtung (Kv) einer Prüfeinrichtung zugeführt, welche eine Identitätsprüfung durchführt, eine Verdrehung der IC-Bausteine (B) um 90°, 180°, 270° erkennt und auch defekte IC-Bausteine (B) erkennt. Die Prüfeinrichtung ist vorzugsweise so ausgebildet, daß zwischen einem Stromversorgungsanschluß des zu prüfenden IC-Bausteines und den Eingängen und/oder Ausgängen ein Strom eingeprägt wird, worauf der Spannungsabfall ermittelt und mit einem vorgegebenen Spannungs-Sollwert verglichen wird. Hierdurch wird eine einfache und äußerst rasche Prüfung zur Erhöhung der Bestücksicherheit ermöglicht.

FIG 1

EP 0 306 653 A1

## Einrichtung zur Positionierung von IC-Bausteinen auf einem Substrat

Die Erfindung betrifft eine Einrichtung zur Positionierung von IC-Bausteinen auf einem Substrat, mit mindestens einer Zuführeinrichtung zur Bereitstellung der IC-Bausteine und mindestens einem Bestückkopf, welcher die IC-Bausteine aus der Zuführeinrichtung entnimmt, in den Bereich des Substrats transportiert und in einer vorgegebenen Bestückposition auf dem Substrat ablegt.

Bei der automatischen Bestückung von Leiterplatten und Keramiksubstraten mit elektronischen Bauteilen, wie Widerständen, Kondensatoren, Dioden, Transistoren, IC-Bausteinen und dergleichen werden die verschiedenen Bauteile in seitlich angeordneten Zuführeinrichtungen bereitgestellt. Die Entnahme der Bauteile erfolgt dann über einen Bestückkopf, welcher das jeweils in einer Entnahmeposition bereitgestellte Bauteil erfaßt, mit Hilfe von vier paarweise angeordneten, zangenförmigen Hebeln zentriert und auf einer vorbestimmten Stelle der Leiterplatte oder des Keramiksubstrats ablegt. Die mit derartigen, beispielsweise aus der US-A-4 135 630 bekannten Bestückautomaten erzielbare Bestücksicherheit hängt in entscheidender Weise davon ab, daß der auf die Entnahmeposition der Zuführeinrichtungen programmierte Bestückkopf die Bauteile dort auch stets in der richtigen Lage antrifft und in der programmierten Bestückposition der Leiterplatte oder des Keramiksubstrats ebenfalls in der richtigen Lage ablegt.

Bei einem aus der DE-A-3 102 206 bekannten Bestückkopf besteht zumindest das untere Ende der zu Aufnahme der Bauteile dienenden Saugpipette aus elektrisch nicht leitendem Werkstoff, wobei die mit dem elektronischen Bauteil zusammenwirkenden zangenförmigen Enden der Hebel elektrisch isoliert angeordnet sind. Durch diese Maßnahme kann dann über ein Hebelpaar ein bestimmter Strom eingespeist werden oder es kann über ein Hebelpaar eine bestimmte Spannung angelegt werden. Insbesondere besteht die Möglichkeit die elektrischen Eigenschaften des jeweils vom Bestückkopf erfaßten Bauteils zu messen bzw. zu prüfen. Eine für die automatische Bestückung unbedingt erforderliche Erkennung der Polarität gepolter Kondensatoren ist mit dem geschilderten Bestückkopf in Verbindung mit entsprechenden elektrischen Erkennungsverfahren ebenfalls möglich. Eine zur Erhöhung der Bestücksicherheit erforderliche Prüfung und Verifizierung von integrierten Schaltungsbausteinen, die im folgenden kurz IC-Bausteine genannt werden, ist mit dem geschilderten Bestückkopf jedoch nicht möglich. Unter dem Begriff IC-Baustein sollen dabei alle Halbleiter mit mehr als zwei Anschlußbeinchen verstanden werden.

Bei der automatischen Bestückung von Leiterplatten oder Keramiksubstraten mit IC-Bausteinen können insbesondere folgende Fehler auftreten:
- Verwechslung von IC-Bausteinen durch das Bedienungspersonal.
- Verpolung der IC-Bausteine durch Zufuhr in verdrehter Lage.
- Fehler durch Elektrostatik. Funktionelle Fehler werden in der Regel bereits beim Hersteller oder gegebenenfalls beim Wareneingangstest erkannt, so daß bis zum Bestückautomaten nur noch Transportschäden auftreten können.
- Mechanische Fehlbehandlung, insbesondere verbogene Anschlußbeinchen.

Der Erfindung liegt die Aufgabe zugrunde bei einer Einrichtung zur Positionierung von IC-Bausteinen auf einem Substrat die Bestücksicherheit zu erhöhen.

Diese Aufgabe wird bei einer gattungsgemäßen Einrichtung dadurch gelöst, daß die IC-Bausteine in einer Zwischenposition der zugeordneten Kontaktiervorrichtung einer Prüfeinrichtung
- zur Identitätsprüfung der IC-Bausteine,
- zum Erkennen einer Verdrehung der IC-Bausteine um $90^\circ$, $180^\circ$ oder $270^\circ$ und
- zum Erkennen von Defekten IC-Bausteinen zuführbar sind.

Der Erfindung liegt die Erkenntnis zugrunde, daß die vom Bestückkopf aufgenommenen IC-Bausteine vor dem eigentlichen Bestückvorgang problemlos der zugeordneten Kontaktiervorrichtung einer Prüfeinrichtung zugeführt werden können, so daß dort für die gesamte Typenvielfalt der IC-Bausteine eine auf die in der Praxis auftretenden Fehler abgestimmte Prüfung vorgenommen werden kann.

Gemäß einer besonders bevorzugten Ausgestaltung der Erfindung umfaßt die Prüfeinrichtung
- eine Konstantstromquelle zum Einprägen eines Stromes zwischen einem Stromversorgungsanschluß und jeweils einem Eingang und/oder Ausgang des zu prüfenden IC-Bausteins,
- eine Spannungsmeßeinrichtung zur Ermittlung des jeweiligen Spannungsabfalles zwischen dem Stromversorgungsanschluß und dem jeweiligen Eingang und/oder Ausgang und
- eine Auswerteeinrichtung zum Vergleich der ermittelten Spannungsabfälle mit vorgegebenen Spannungs-Sollwerten.

Die vorstehend geschilderte Prüfeinrichtung beruht auf der Erkenntnis, daß für alle IC-Bausteine ein gemeinsames Modell entwickelt werden kann. Dieses Modell beschreibt IC-Bausteine folgendermaßen:
- Alle integrierten Schaltungen haben mindestens zwei Stromversorgungsanschlüsse. Dabei handelt es sich um den Stromversorgungsanschluß mit der höchsten positiven Spannung und den Stromversorgungsanschluß mit der betragsmäßig höchsten negativen Spannung.

- Alle IC-Bausteine haben eine beliebige Anzahl von Eingängen, eine beliebige Anzahl von Ausgängen und gegebenenfalls eine beliebige Anzahl solcher Anschlüsse, die sowohl als Eingang als auch als Ausgang dienen.

- Alle Eingänge und/oder Ausgänge sind jeweils über eine Schutzbeschaltung mit dem positiven Stromversorgungsan schluß und über eine weitere Schutzbeschaltung mit dem negativen Stromversorgungsanschluß verbunden.

- Die beiden Stromversorgungsanschlüsse sind ebenfalls über eine Schutzbeschaltung miteinander verbunden.

Wie bereits erwähnt wurde, ist dieses Modell für alle IC-Bausteine gültig. Denn, bedingt durch die hohe Empfindlichkeit sämtlicher IC-Bausteine gegenüber Spannungen, die den Betrag der Versorgungsspannungen überschreiten, sind alle IC-Bausteine mit Schutzbeschaltungen versehen, auch wenn sie in den Datenblättern nur in den seltensten Fällen aufgeführt werden. Diese Schutzbeschaltungen können je nach Technologie und Hersteller sehr unterschiedlich verwirklicht werden. Die meisten Ausführungen begnügen sich mit Dioden, Zenerdioden und Transistoren. Ein zusätzlicher Serienwiderstand kann bei Eingangsschutzbeschaltungen Verwendung finden. Da jedoch alle Schutzbeschaltungen in erster Näherung die Kennlinie eines pn-Überganges aufweisen, können sie in einer allgemeinen Darstellung des Modells durch Dioden repräsentiert werden. Werden nun bei diesen Dioden die Diodenspannungen in Durchlaßrichtung gemessen und mit den entsprechenden Spannungs-Sollwerten eines bekannt guten IC-Bausteins verglichen, so kann aufgrund dieses Vergleiches eine Aussage über eventuelle Fehler gemacht werden. Ist ein IC-Baustein von außen zerstört oder beschädigt worden, so hat sich auch der Wert der Durchlaßspannung der entsprechenden Diode verändert und zwar von wesentlich größerem Betrag als der Betrag der Toleranzen unter den IC-Bausteinen. Es ist nicht möglich eine Diode zu zerstören ohne den IC-Baustein zu verletzen und es ist auch nicht möglich, den IC-Baustein zu verletzen ohne eine Diode zu verletzen. Damit existiert ein Prüfverfahren für IC-Bausteine, welches mit äußerst geringem meßtechnischem Aufwand, einem Minimum an Informationsbedarf und durch Teachen nur eines bekannt guten IC-Bausteins aus jedem Los alle der erwähnten Fehlermöglichkeiten erkennt. Der hierzu erforderliche Informationsbedarf umfaßt dabei die Gehäuseform, sowie die Lage mindestens eines der beiden Stromversorgungsanschlüsse. Verbogene Anschlußbeinchen können dabei durch fehlenden Kontakt mit der zugeordneten Kontaktiervorrichtung er kannt werden.

Gemäß einer weiteren bevorzugten Ausgestaltung der Erfindung sind die Eingänge und/oder Ausgänge des zu prüfenden IC-Bausteins über einen Multiplexer nacheinander ansteuerbar. Mit Hilfe dieses Multiplexers können dann die erforderlichen Messungen äußerst rasch durchgeführt werden. Vorzugsweise ist dann jeder Pol der Konstantstromquelle über einen zugeordneten Multiplexer mit jedem Stromversorgungsanschluß und jedem Eingang und/oder Ausgang des zu prüfenden IC-Bausteins verbindbar. Hierdurch kann das Einprägen des Stromes mit beliebiger Polung zwischen beliebigen Anschlüssen des zu prüfenden IC-Bausteins vorgenommen werden.

Weiterhin hat es sich als vorteilhaft erwiesen, als Auswerteeinrichtung einen Rechner oder Mikroprozessor vorzusehen. In diesem Fall ist es dann auch zweckmäßig, die Multiplexer durch den Rechner oder Mikroprozessor zu steuern. Zusätzlich können dann auch in den Rechner oder Mikroprozessor die Bauform, die Lage der Stromversorgungsanschlüsse, die Anzahl der Ein- und Ausgänge und die zulässigen Werte der Spannungsabfälle des jeweils zu prüfenden IC-Bausteins gespeichert werden. Selbst komplexe IC-Bausteine mit bis zu 124 Anschlüssen können dann in maximal 1,74 Sekunden vollständig verifiziert und geprüft werden.

Ausführungsbeispiele der Erfindung sind in der Zeichnung dargestellt und werden im folgenden näher beschrieben.

Es zeigen

Fig. 1 die automatische Bestückung einer Leiterplatte mit IC-Bausteinen, die auf ihrem Weg zwischen Zuführeinrichtung und Leiterplatte der zugeordneten Kontaktiervorrichtung einer Prüfeinrichtung zugeführt werden,

Fig. 2 ein gemeinsames Modell für alle IC-Bausteine,

Fig. 3 und 4 das auf dem Modell gemäß Fig. 2 beruhende Prinzip der Prüfung von IC-Bausteinen und

Fig. 5 eine Prüfeinrichtung für IC-Bausteine.

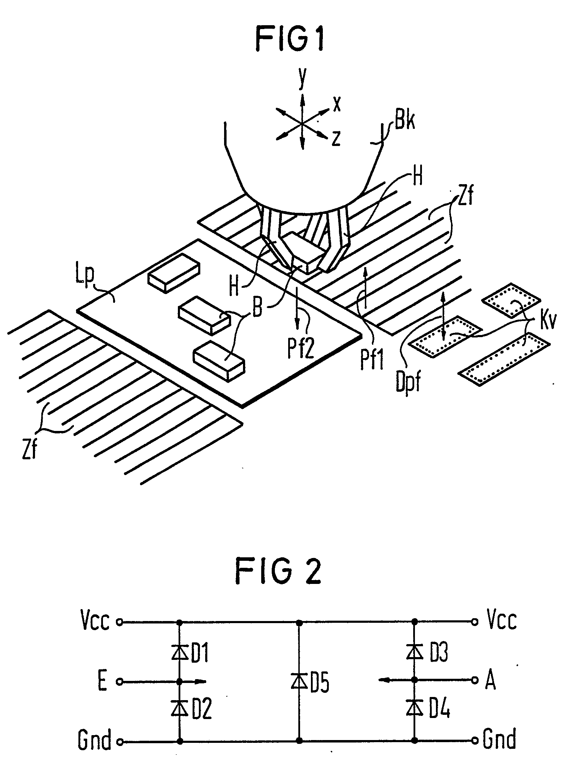

Fig. 1 zeigt in stark vereinfachter schematischer Darstellung des Prinzip der Bestückung einer Leiterplatte Lp mit oberflächenmontierbaren Bauteilen. Diese meist als SMD-Bauteile bezeichneten oberflächenmontierbaren Bauteile werden dabei in seitlich angeordneten Zuführeinrichtungen Zf bereitgestellt. Die für IC-Bausteine B aufgezeigte Entnahme der Bauteile erfolgt über einen in x-Richtung, y-Richtung und z-Richtung verfahrbaren Bestückkopf Bk, welcher den in der zugeordneten Zuführeinrichtung Zf bereitgestellten IC-Baustein B erfaßt, mit Hilfe von vier paarweise angeordneten zangenförmigen Hebeln H zentriert und auf der programmierten Bestückposition auf der Leiterplatte Lp ablegt. Zwischen der durch einen Pfeil Pf1 angedeuteten Entnahme des IC-Bausteins B aus der Zuführeinrichtung Zf und der durch einen Pfeil Pf2 angedeuteten Ablage auf der Leiterplatte Lp wird der IC-Baustein B jedoch in einer Zwischenposition der zugeordneten Kontaktiervorrichtung Kv einer Prüfeinrichtung zugeführt, wobei das Absenken zur Kontaktierung und das erneute Anheben des IC-Bausteins B durch einen Doppelpfeil Dpf angedeutet ist. Bei den in Fig. 1 schematisch aufgezeigten Kontaktiervorrichtungen Kv handelt es sich um sogenannte Testnester die auf die jeweilige IC-Bauform abgestimmt sind und beispielsweise als Nadeladapter ausgebildet sind, deren Kontaktnadeln die einzelnen SMD-Anschlüsse sicher kontaktieren. Insbesondere für IC-Bausteine mit Anschlußbeinchen sind selbstverständlich auch entsprechende Sockel als Kontaktiervorrichtung möglich. Nach dem Kontaktieren des jeweiligen IC-Bausteins B mit Hilfe der zugeordneten Kontaktiervorrichtung Kv werden in der an späterer Stelle noch zu erläuternden Prüfeinrichtung folgende Prüfvorgänge durchgeführt:

- Identitätsprüfung des jeweiligen IC-Bausteins B.
- Erkennung einer Verdrehung des IC-Bausteins B um 90°, 180° oder 270°.
- Erkennung von defekten IC-Bausteinen B.

Wird dabei festgestellt, daß der Bestückkopf Bk ein falsches Bauteil erfaßt hat, so wird dieses wieder abgelegt und der richtige IC-Baustein B aus der zugeordneten Zuführeinrichtung Zf entnommen. Wird eine Verdrehung des IC-Bausteins B erkannt, so wird diese vor dem Absetzen auf der Leiterplatte Lp durch eine entsprechende Drehung des Bestückkopfes Bk bzw. dessen Saugpipette korrigiert. Wird der Defekt eines IC-Bausteins B ermittelt, so wird dieser nicht auf der Leiterplatte Lp abgelegt, sondern verworfen.

Fig. 2 zeigt ein allen handelsüblichen IC-Bausteinen gemeinsames Modell mit folgenden Merkmalen:

- Es sind mindestens zwei Stromversorgungsanschlüsse vorgesehen, wobei mit Vcc der Stromversorgungsanschluß mit der höchsten positiven Spannung und mit Gnd der Stromversorgungsanschluß mit der betragsmäßig höchsten negativen Spannung, d.h. die Masse bezeichnet ist.
- Es existiert eine beliebige Anzahl von mit E bezeichneten Eingängen und eine beliebige Anzahl von mit A bezeichneten Ausgängen, wobei auch Anschlüsse vorliegen können, die sowohl als Eingang E und als Ausgang A dienen.
- Alle Eingänge E und Ausgänge A sind jeweils über eine Schutzbeschaltung mit dem Stromversorgungsanschluß Vcc und über eine weitere Schutzbeschaltung mit dem Stromversorgungsanschluß Gnd verbunden. Diese Schutzbeschaltungen werden durch Dioden D1, D2, D3 und D4 repräsentiert.
- Die beiden Stromversorgungsanschlüsse Vcc und Gnd sind ebenfalls über eine Schutzbeschaltung miteinander verbunden. Diese Schutzbeschaltung wird durch eine Diode D5 repräsentiert.

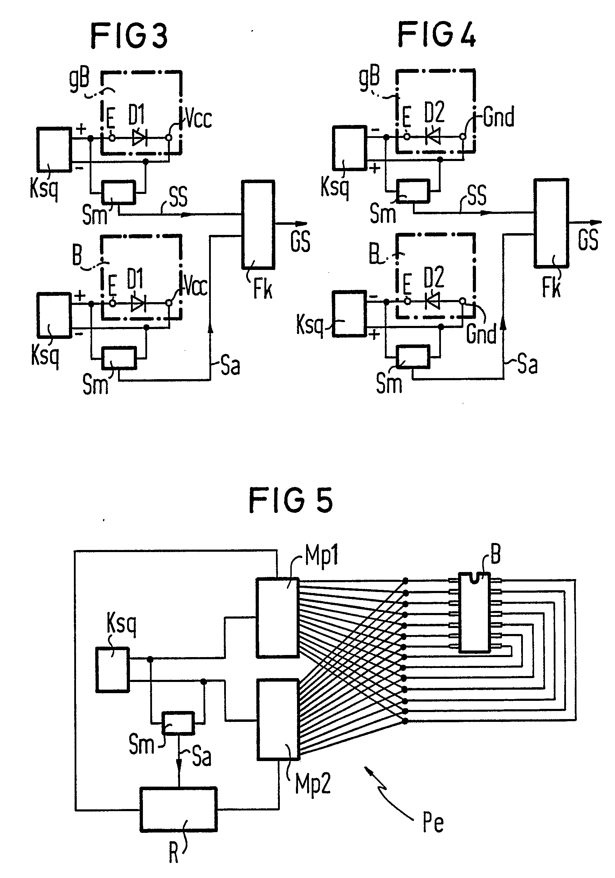

Basierend auf dem in Fig. 2 dargestellten Modell zeigt Fig. 3 einen strichpunktiert angedeuteten IC-Baustein B mit dem positiven Stromversorgungsanschluß Vcc, einem Eingang E und der dazwischen angeordneten Diode D1. Mit einer beispielsweise für 50 μA ausgelegten Konstantstromquelle Ksq wird ein Strom zwischen den Stromversorgungsanschluß Vcc und den Eingang E eingeprägt, wobei der Eingang E mit dem positiven Pol + und Vcc und mit dem negativen Pol - der Konstantstromquelle Ksq verbunden ist. Der an dem Stromversorgungsanschluß Vcc und dem Eingang E auftretende Spannungsabfall Sa wird dabei durch eine Spannungsmeßeinrichtung Sm erfaßt. Die Konstantstromquelle Ksq besteht im einfachsten Fall aus einer Konstantspannungsquelle und einem in Serie dazu geschalteten Widerstand. Als Spannungsmeßeinrichtung Sm wird vorzugsweise ein Analog-Digital-Wandler verwendet.

Gleichzeitig mit der vorstehend beschriebenen Messung wird an einem bekannt guten IC-Baustein gB der auch häufig als "Golden Device" bezeichnet wird, eine identische Messung durchgeführt, wobei der hier zwischen dem Stromversorgungsanschluß Vcc und dem Eingang E auftretende Spannungsabfall als Spannungs-Sollwert SS anzusehen ist. Der Spannungsabfall Sa und der Spannungs-Sollwert SS werden dann in einem Fenster-Komparator FK miteinander verglichen. Ein Gut/Schlecht Signal GS gibt dann an, ob die Abweichung zwischen dem Spannungsabfall Sa und dem Spannungs-Sollwert SS noch zulässig ist oder nicht, d.h. ob ein Fehler oder Defekt vorliegt oder nicht. Nach dem anhand der Fig. 3 erläuterten Meßprinzip werden in einem ersten Meßzyklus sämtliche Anschlüsse des IC-Bausteins B gegen den positiven Stromversorgungsanschluß Vcc vermessen. Gemäß Fig. 4 werden dann in einem zweiten Meßzyklus sämtliche Anschlüsse des IC-Bausteins B gegen den negativen Stromversorgungsanschluß Gnd vermessen. Dieser zweite Meßzyklus ist in Fig. 4 wiederum am Beispiel eines Eingangs E aufgezeigt, der hier über die Diode D2 mit dem negativen Stromversorgungsanschluß Gnd verbunden ist. Der Eingang E ist beim zweiten Meßzyklus dann mit dem negativen Pol - der Konstantstromquelle Ksq verbunden, während der negative Stromversorgungsanschluß Gnd mit dem positiven Pol + der Konstantstromquelle Ksq verbunden ist.

Fig. 5 zeigt eine Prüfeinrichtung Pe für IC-Bausteine B, deren Kontaktiervorrichtungen Kv in Fig. 1 zu erkennen sind. Im dargestellten Ausführungsbeispiel wird mit einer dieser in Fig. 5 nicht näher dargestellten Kontaktiervorrichtungen Kv ein IC-Baustein B mit der Bezeichnung 7400 kontaktiert. Jeder der 14 Anschlüsse dieses IC-Bausteins B ist dabei mit einem ersten Multiplexer Mp1 und einem zweiten Multiplexer Mp2 derart verbunden, daß das Einprägen des Stromes der Konstantstromquelle Ksq zwischen beliebigen Anschlüssen mit beliebiger Polung vorgenommen werden kann. Die Steuerung dieser beiden Multiplexer Mp1 und Mp2 entsprechend der anhand der Fig. 3 und 4 beschriebenen Meßzyklen wird von einem Rechner R übernommen, welchem auch die jeweils ermittelten Spannungsabfälle Sa zugeführt werden. In diesem Rechner R sind die an einem bekannt guten Baustein gB ermittelten Spannungs-Sollwerte SS (vergleiche Fig. 3 und 4) bzw. die entsprechenden Toleranzfelder gespeichert, so daß die unmittelbaren Vergleichsmessungen entfallen können. Neben diesen zulässigen Werten der Spannungsabfälle Sa sind in dem Rechner R auch noch die Lage der Stromversorgungsanschlüsse Vcc, Gnd und die Anzahl der Ein- und Ausgänge E, A (vergleiche Fig. 2) des jeweils zu prüfenden IC-Bausteins B gespeichert. Ergeben sich bei einem Meßzyklus gleich mehrere unzulässige Spannungsabfälle Sa, so kann der Rechner R durch eine Art elektronische Drehung leicht ermitteln, ob der IC-Baustein B in einer verdrehten Lage aufgenommen und in die Kontaktiervorrichtung Kv (vergleiche Fig. 1) eingesetzt wurde.

Die vorstehend geschilderte Prüfeinrichtung Pe ist für die Prüfung von IC-Bausteinen B in Bipolartechnologie, CMOS-Technologie und NMOS-Technologie geeignet. Die Messungen werden dabei im stromlosen Zustand der IC-Bausteine B vorgenommen, d.h. es handelt sich bei dieser Prüfung um keinen Funktionstest. Im Hinblick auf die zulässigen Abweichungen der ermittelten Spannungsabfälle Sa von den gemessenen oder gespeicherten Werten eines bekannt guten Bausteins gelten für die verschiedenen Technologien folgende Toleranzgrenzen:

1. Bipolartechnologie: ± 0,15 Volt oder ± 15 % des Teachwertes, vorzugsweise ± 0,1 Volt oder ± 10 % des Teachwertes. Liegt jeweils nur einer der beiden Werte innerhalb der vorgegebenen Toleranzen, so ist die Abweichung als zulässig anzusehen.

2. CMOS-Technologie: ± 0,1 Volt, vorzugsweise ± 0,05 Volt.

3. NMOS-Technologie: ± 0,5 Volt.

Die beschriebene Prüfeinrichtung Pe ermöglicht bei der automatischen Bestückung von Leiterplatten oder Keramiksubstraten eine in weniger als 2 Sekunden durchführbare Kurzprüfung, durch welche die Bestücksicherheit in einem ganz erheblichen Maße gesteigert werden kann.

## Ansprüche

1. Einrichtung zur Positionierung von IC-Bausteinen auf einem Substrat, mit mindestens einer Zuführeinrichtung zur Bereitstellung der IC-Bausteine und mindestens einem Bestückkopf, welcher die IC-Bausteine aus der Zuführeinrichtung entnimmt, in den Bereich des Substrats transportiert und in einer vorgegebenen Bestückposition auf dem Substrat ablegt,
**dadurch gekennzeichnet,**
daß die IC-Bausteine (B) in einer Zwischenposition der zugeordneten Kontaktiervorrichtung (Kv) einer Prüfeinrichtung (Pe)
- zur Identitätsprüfung der IC-Bausteine (B),
- zum Erkennen einer Verdrehung der IC-Bausteine (B) um 90°, 180° oder 270° und
- zum Erkennen von defekten IC-Bausteinen (B)
zuführbar sind.

2. Einrichtung nach Anspruch 1,
**dadurch gekennzeichnet,**
daß die Prüfeinrichtung (Pe)
- eine Konstantstromquelle (Ksq) zum Einprägen eines Stroms zwischen einem Stromversorgungsanschluß (Vcc,Gnd) und jeweils einem Eingang (E) und/oder Ausgang (A) des zu prüfenden IC-Bausteins (B),
- eine Spannungsmeßeinrichtung (Sm) zur Ermittlung des jeweiligen Spannungsabfalles zwischen dem Stromversorgungsanschluß (Vcc,Gnd) und dem jeweiligen Eingang (E) und/oder Ausgang (A) und
- eine Auswerteeinrichtung (FK,R) zum Vergleich der ermittelten Spannungsabfälle (Sa) mit vorgegebenen Spannungs-Sollwerten (SS)
umfaßt.

3. Einrichtung nach Anspruch 2,
**dadurch gekennzeichnet,**
daß die Eingänge (E) und/oder Ausgänge (A) des zu prüfenden IC-Bausteines (B) über einen Multiplexer (Mp1,Mp2) nacheinander ansteuerbar sind.

4. Einrichtung nach Anspruch 3,
**dadurch gekennzeichnet,**
daß jeder Pol ( +, -) der Konstantstromquelle (Ksq) über einen zugeordneten Multiplexer (Mp1,Mp2) mit jedem Stromversorgungsanschluß (Vcc,Gnd) und jedem Eingang (E) und/oder Ausgang (A) des zu prüfenden IC-Bausteines (B) verbindbar ist.

5. Einrichtung nach einem der Ansprüche 2 bis 4,
**dadurch gekennzeichnet,**
daß als Auswerteeinrichtung (R) ein Rechner (R) oder Mikroprozessor vorgesehen ist.

6. Einrichtung nach den Ansprüchen 4 und 5,
**dadurch gekennzeichnet,**
daß die Multiplexer (Mp1,Mp2) durch den Rechner (R) oder Mikroprozessor steuerbar sind.

7. Einrichtung nach Anspruch 6,
**dadurch gekennzeichnet,**
daß in dem Rechner (R) oder Mikroprozessor die Bauform, die Lage der Stromversorgungsanschlüsse (Vcc,Gnd), die Anzahl der Ein- und Ausgänge (E,A) und die zulässigen Werte der Spannungsabfälle (Sa) des jeweils zu prüfenden IC-Bausteins (B) speicherbar sind.

# FIG 1

# FIG 2

FIG 3

FIG 4

FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 502 829 (ST. CYR) * Spalte 7, Zeile 45 - Spalte 8, Zeile 5; Zusammenfassung; Figuren 1,5B * | 1 | G 01 R 31/28 H 05 K 13/08 H 05 K 13/04 |
| Y | --- | 2,5 | |
| Y | PATENT ABSTRACTS OF JAPAN, Band 7, Nr. 138 (P-204)[1283], 16. Juni 1983; & JP-A-58 52 581 (FUJITSU K.K.) 28-03-1983 * Zusammenfassung * | 2,5 | |
| X | US-A-4 099 325 (BAKER) * Spalte 2, Zeilen 16-35; Figuren 1,3 * | 1 | |
| P,X | EP-A-0 257 546 (MATSUSHITA ELECTRIC INDUSTRIAL CO.) * Spalte 3, Zeile 23 - Spalte 4, Zeile 57; Figuren 1,2 * | 1 | |
| A | --- | 2,5-7 | |
| A | IBM TECHNICAL DISCLOSURE BULLETIN, Band 19, Nr. 1, Juni 1976, Seiten 244-245, New York, US; R. BAUER et al.: "Electrical inspection of logic cards through nodal measurement testing" * Insgesamt * | 2 | **RECHERCHIERTE SACHGEBIETE (Int. Cl.4)** G 01 R 31/00 H 05 K 13/00 H 01 L 21/00 B 07 C 5/00 |
| A | HEWLETT PACKARD JOURNAL, Band 35, Nr. 6, Juni 1984, Seiten 3-8, Amstelveen, NL; Y. NARIMATSU et al.: "A parametric test system for accurate measurement of wafer-stage ICs" * Seite 4, linke Spalte, Zeile 12 - Seite 4, rechte Spalte, Zeile 24; Figur 2 * | 3,5-7 | |

Der vorliegende Recherchenbericht wurde für alle Patentansprüche erstellt

| Recherchenort | Abschlußdatum der Recherche | Prüfer |
|---|---|---|
| DEN HAAG | 30-11-1988 | TRELEVEN C. |

EPO FORM 1503 03.82 (P0403)